(19) Europäisches Patentamt
European Patent Office
Office européen des brevets

(11) **EP 1 664 861 B1**

(12) **EUROPÄISCHE PATENTSCHRIFT**

(45) Veröffentlichungstag und Bekanntmachung des Hinweises auf die Patenterteilung:
**30.06.2010 Patentblatt 2010/26**

(51) Int Cl.:
***G02B 5/20*** *(2006.01)*

(21) Anmeldenummer: **04786722.1**

(22) Anmeldetag: **07.09.2004**

(86) Internationale Anmeldenummer:
**PCT/DE2004/002000**

(87) Internationale Veröffentlichungsnummer:
**WO 2005/024612 (17.03.2005 Gazette 2005/11)**

(54) **OPTISCHE FUNKTIONSSCHICHTEN, INSBESONDERE ZINKOXID-SULFID-SCHICHTEN MIT VARIABLER DIELEKTRISCHER RESPONSE**

OPTICAL FUNCTIONAL LAYERS, PARTICULARLY ZINC OXIDE-SULFIDE LAYERS HAVING A VARIABLE DIELECTRIC RESPONSE

COUCHES DE FONCTION OPTIQUES, NOTAMMENT COUCHES OXYDE-SULFURE DE ZINC, A REPONSE DIELECTRIQUE VARIABLE

(84) Benannte Vertragsstaaten:
**AT BE BG CH CY CZ DE DK EE ES FI FR GB GR HU IE IT LI LU MC NL PL PT RO SE SI SK TR**

(30) Priorität: **08.09.2003 DE 10341681**

(43) Veröffentlichungstag der Anmeldung:
**07.06.2006 Patentblatt 2006/23**

(60) Teilanmeldung:
**09015150.7 / 2 175 293**

(73) Patentinhaber: **Justus-Liebig- Universitat Giessen 35390 Giessen (DE)**

(72) Erfinder:
• **MEYER, Bruno, K. 35440 Grossen-Linden (DE)**
• **FARANGIS, Baker 35390 Giessen (DE)**
• **HOFMANN, Detlev 35625 Hüttenberg (DE)**
• **KRÄMER, Thorsten 35435 Wettenberg (DE)**
• **POLITY, Angelika 61241 Bad Nauheim (DE)**

(74) Vertreter: **Buchhold, Jürgen Patentanwälte Olbricht & Buchhold Am Weinberg 15 35096 Weimar/Lahn (DE)**

• **YOO Y-Z ET AL: "S doping in ZnO film by supplying ZnS species with pulsed-laser-deposition method" APPLIED PHYSICS LETTERS, AMERICAN INSTITUTE OF PHYSICS. NEW YORK, US, Bd. 81, Nr. 20, 11. November 2002 (2002-11-11), Seiten 3798-3800, XP012032518 ISSN: 0003-6951 in der Anmeldung erwähnt**
• **PLATZER-BJORKMAN C ET AL: "Atomic layer deposition of Zn(O,S) buffer layers for high efficiency Cu(In,Ga)Se2 solar cells" PROCEEDINGS OF 3RD WORLD CONFERENCE ON PHOTOVOLTAIC ENERGY CONVERSION (IEEE CAT. NO.03CH37497) ARISUMI PRINTING INC JAPAN, JAPAN, Bd. 1, 18. Mai 2003 (2003-05-18), Seiten 461-464 Vol.1, XP002317884 ISBN: 4-9901816-0-3**
• **YOUSFI E B ET AL: "Cadmium-free buffer layers deposited by atomic later epitaxy for copper indium diselenide solar cells" THIN SOLID FILMS, ELSEVIER-SEQUOIA S.A. LAUSANNE, CH, Bd. 361-362, Nr. 1, Februar 2000 (2000-02), Seiten 183-186, XP004187467 ISSN: 0040-6090**
• **SANDERS B W ET AL: "ZINC OXYSULFIDE THIN FILMS GROWN BY ATOMIC LAYER DEPOSITION" CHEMISTRY OF MATERIALS, AMERICAN CHEMICAL SOCIETY, WASHINGTON, US, Bd. 4, Nr. 5, 1. September 1992 (1992-09-01), Seiten 1005-1011, XP000306451 ISSN: 0897-4756**

(56) Entgegenhaltungen:
**EP-A- 1 178 543    US-A- 5 337 191**

- ORENT T: "Stress modification in sputtered zinc sulfide and zinc oxysulfide thin films" JOURNAL OF VACUUM SCIENCE & TECHNOLOGY A (VACUUM, SURFACES, AND FILMS) USA, Bd. 9, Nr. 4, Oktober 1991 (1991-10), Seiten 2447-2452, XP002317885 ISSN: 0734-2101
- LOKHANDE C D ET AL: "Preparation of Znx(O,S)y thin films using modified chemical bath deposition method" APPLIED SURFACE SCIENCE ELSEVIER NETHERLANDS, Bd. 187, Nr. 1-2, 14. Februar 2002 (2002-02-14), Seiten 101-107, XP002317886 ISSN: 0169-4332

- PHILIP WERNER BAUMEISTER: "Optische Beschichtungstechnologie" 1998, PHILIP WERNER BAUMEISTER * Seiten 3-16, Absatz 3.3.2.7.1 *

**Beschreibung**

**[Beschreibung und Stand der Technik]**

Die vorliegende Erfindung betrifft das Gebiet der funktionalen Schichten, die auf die zu schützenden Materialien oder Substrate wie z.B. mineralisches Glas, Plexiglas oder Folien wie Kunststofffolien aufgebracht werden können und die Transmission des einfallenden Lichtes ab einer bestimmten, meist bei der Produktion eingestellten Wellenlänge verhindern, um Schädigungen durch Licht zu vermeiden.

Die vorliegende Erfindung betrifft insbesondere eine funktionale Schicht aus $ZnO_xS_{1-x}$, deren Absorption oder Transmission in einem vorher einstellbaren Wellenlängenbereich eine abrupte Änderung erfährt, sowie eine derartige Schicht, die elektrisch leitfähig ist. Des weiteren betrifft die Erfindung ein Verfahren zur Herstellung derartiger Schichten.

Durch Bestrahlung mit Licht können Materialien verändert oder geschädigt werden. Beispiele hierfür sind die Schädigungen von biologischem Gewebe durch Verbrennung (Sonnenbrand), von funktionalen Molekülstrukturen in organischen elektro-optischen Bauelementen wie organischen lichtemittierenden Dioden (OLED), oder organischen Solarzellen, von Festkörpern oder von Pigmentfarben, wie sie in Bildern verwendet werden oder von Fensterbeschichtungen mit elektrisch schaltbarer Transmission (elektrochrome Fenster).

Diese Aufgabe löst man im Stand der Technik durch Filter, die in einem langwelligen Bereich das Licht möglichst ungestört transmittieren und ab einer bestimmten Wellenlänge $\lambda_0$ möglichst scharf und vollständig abschneiden. Diese Wellenlänge hängt von dem Schädigungseffekt des Lichtes auf das zu schützende Material ab. Derartige Filter bestehen in der Regel aus eingefärbten Gläsern. Für jede Filterfunktion muss hierbei eine gesonderte Schmelze mit den entsprechenden Zusätzen angesetzt werden. Diese Filter weisen jedoch in der Regel einen breiten Übergangsbereich bei $\lambda_0$ auf.

Verbesserungen erzielt man durch die Kombination mit Interferenzfiltern. Durch den Abbau der Ozonschicht im Bereich der Polarregionen ist jedoch der Bedarf entstanden, auch in Gebäuden einen entsprechenden Schutz zu gewährleisten. Da Floatglas hierfür nur eingeschränkt geeignet ist, werden Materialien gesucht, die einerseits das sichtbare Sonnenlicht möglichst uneingeschränkt transmittieren und andererseits das UV-Licht nahezu vollkommen abschneiden.

Für transparente leitfähige Funktionsschichten setzt man transparent conductive oxides (TCO) wie $In_2O_3$:Sn (ITO), ZnO:Al, $SnO_2$:F ein, die in der Regel in pyrolytischen oder Sputterprozessen hergestellt werden. Sie zeigen allerdings bis in den ultravioletten Spektralbereich hohe Transparenz, darüber hinaus kann die Absorptionskante nicht variiert werden.

Es ist bekannt, dass Legierungen oder Gemische dielektrischer Materialien Eigenschaften besitzen können, die zwischen oder auch außerhalb (bowing) derer der Ursprungssubstanzen liegen. Dies wurde für das vorteilhafte ZnO sowohl durch anionische als auch durch kationische Substitution getestet.

Eine Schwefeldotierung von ZnO-Schichten, die mit alternierender, gepulster Laserdeposition (PLD) von zwei keramischen Targets (ZnO/ZnS) auf Saphir hergestellt wurden, ergibt eine erhöhte UV-Absorption bei einem maximalen Anteil von 14 % Schwefel in ZnO (Y.-Z. Yoo et al., Appl. Phys. Lett. 81, 3798 (2002)). Dies ist jedoch mit dem Nachteil einer starken Verbreiterung der Absorptionskante verbunden, da sich bei höherer Schwefel-Konzentration Fremdphasen ausbilden. Verschiebungen der Absorptionskante von ZnO in Richtung UV können durch Legierung mit MgO (3.3 bis 4.0 eV) oder in Richtung sichtbarer Spektralbereich mit CdO (3.3 bis 3.0 eV) realisiert werden (T. Makino et al., Appl. Phys. Lett. 78, 1237 (2001)).

Bisher ist jedoch keine ternäre Verbindung synthetisiert worden, die den Bereich 3.7 eV bis 2.5 eV abdecken könnte.

In der Patentschrift US 20030042851 A1 (March 6, 2003), Iwata et al., wird eine quaternäre ZnOSSe-Schicht auf SiliziumSubstraten abgeschieden, die als lichtemittierendes Bauteil Einsatz finden soll. Dazu wird mit theoretischen Berechnungen die Bandlückenenergien für ZnSSe, ZnOS und ZnOSe abgeschätzt. Danach variiert die Bandlückenenergie in Abhängigkeit von der Zusammensetzung der quarternären Verbindung vom UV über den sichtbaren bis in den infraroten Bereich. Experimentelle Ergebnisse aus diesem Patent liegen nur für ZnOSe (nicht für ZnSSe, nicht für ZnOS vor) mit einem maximalen Se-Anteil von 15 % vor, das ebenfalls mittels PLD hergestellt wurde. Insbesondere wurde kein Verfahren zur Herstellung von ZnOS-Mischsystemen offenbart. Gegenwärtig sind auch keine anderen Publikationen bekannt, die eine realistische Darstellung oder Herstellung eines ZnOS Mischsystems präsentieren.

Yousfi et al. (Thin Solid Films 361 - 362 (2000) 183- 186) offenbart die Abscheidung von Cadmium-freien Halbleiterschichten, insbesondere ZnOS- Schichten mittels PLD, wobei optimale Schichten bei Werten von x = 0.95 bis 0,9 erreicht werden.

Orent et al. (J. Vac. Sci. Technol. A 9(4), Juli/August 1991) sieht die Herstellung von ZuS- und ZnOS-Dünnschichten mittels Sputtertechnik vor, wobei $ZnSO_4$-freie Schichten nur in einen Bereich von x < 0,25 erreicht werden.

Zur Erzielung einer abrupten Absorptionskante, wurden bisher dielektrische Schichten eingesetzt, die durch die Materialeigenschaften definiert ist. Damit kann aber die Zielsetzung maximaler Transmission oberhalb einer gewünschten Wellenlänge bei minimaler Transmission unterhalb dieser Wellenlänge nicht erreicht werden.

Zur Umgehung der Schwierigkeiten (Verbreiterung der Absorptionskante) beim PLD-Verfahren zur Herstellung von $ZnO_xS_{(1-x)}$ wurde nun auf industrielle Methoden zur Herstellung von ZnO zurückgegriffen. Hierzu wurde reaktives Sputtern von metallischen Zn-Targets unter Sauerstoff- und/oder Schwefelwasserstoff-Zugabe eingesetzt. Auch hier konnten keine Legierungsschichten von ZnOS abgeschieden werden; Deposition fand nur in den Bereichen mit überwiegendem O- oder S-Gehalt (um 90%) statt, während die gewünschte Co-Deposition nicht festgestellt wurde.

Eine probate Methode zur Umgehung dieser Schwierigkeiten stellt die Verwendung keramischer ZnO-Targets dar. Jedoch konnte auch hier in einem weiten Leistungs-, Temperatur- und H2S-Fluss-Bereich kein weiterer Erfolg, d.h. keine Herstellmöglichkeit einer Legierung, festgestellt werden.

## [Aufgabe der Erfindung]

Aufgabe der Erfindung ist es daher eine optische Funktionsschicht vorzusehen, welche eine im Bereich des UV (z.B. im Bereich von ca. 2.6 eV bis 3.8 eV) bei einer Wellenlänge $\lambda_0$ einstellbare, scharfe Absorptionskante und eine maximale Transmission oberhalb der gewünschten Wellenlänge bei minimaler Transmission unterhalb dieser Wellenlänge aufweist.

Weiterhin ist es Aufgabe der vorliegenden Erfindung ein Verfahren zur Herstellung einer solchen Funktionsschicht vorzusehen. Eine dritte Aufgabe der vorliegenden Erfindung ist es ein optisches Funktionselement vorzusehen, welches die erfindungsgemäße Funktionsschicht umfasst und schützt.

Die erste Aufgabe wird erfindungsgemäß mit einer optischen Funktionsschicht gemäß Anspruch 2 gelöst. Die zweite Anfgabe und mit einen Verfahren gemäß Anspruch 1 gelöst. Die dritte Aufgabe wird mit einem optischen Funktionschement gemäß Anspruch 5 gelöst.

Weiterbildungen sind Gegen Stand der Ansprüche 3 und 4. Besondere Verwendungen sind in den Ansprüchen 6 und 7 augegeben.

Überraschenderweise wurde festgestellt, dass sich das Mischsystem ZnOS komplett mischbar als kristalline Dünnschicht synthetisieren lässt und bei der Herstellung die Anteile von O und S in ganzen Bereich (von x=0 bis x=1) einstellen lassen, wobei die daraus resultierende optische Funktionsschicht eine scharfe Absorptionskante mit sehr hoher Transmission bei höheren und sehr geringer Transmission bei niedrigeren Wellenlängen -im Vergleich zur Absorptionskante- aufweist.

Die Bandlückenenergie Eg (x) eines ternären Verbindungshalbleiters wie $ZnO_xS_{(1-x)}$ variiert in der Regel nichtlinear zwischen den binären Endpunkten $E_g$ (ZnO) und $E_g$ (ZnS), ausgedrückt über den "bowing" Parameter b, der den Unterschied in den Elektronegativitäten von Schwefel und Sauerstoff widerspiegelt:

$$E_g \ (x) \ = \ x \ E_g \ (ZnO) \ + \ (1-x) \ E_g \ (ZnS) \ - \ b \ x \ (1-x) \ (*)$$

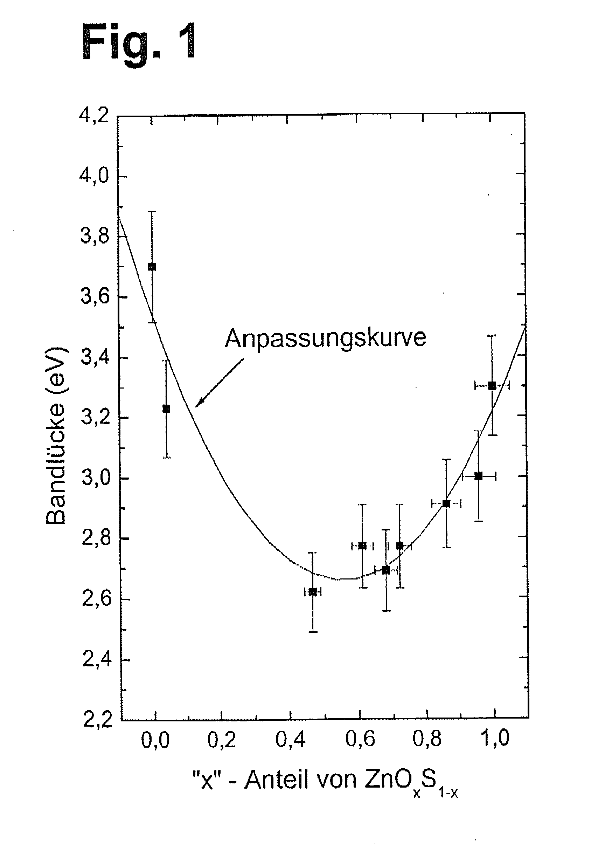

Fig. 1 zeigt dazu die gemessene Verschiebung der Bandlücke legierter $ZnO_xS_{(1-x)}$- Proben als Funktion des Sauerstoffanteils im Bereich von 0 bis 1. Die eingezeichnete Kurve ist eine Anpassung der Messwerte an die Funktion.

Überraschenderweise ist der experimentell gefundene bowing-Parameter von 2.5 eV viel kleiner als der im Patent US 20030042851 A1 (March 6, 2003), Iwata et al. theoretisch vorhergesagte von 12 eV. Damit verschiebt sich die Bandlücke bis ca. 2.6 eV (je nach Messfehler auch bis zu 2.4 eV), d.h. in den blauen Spektralbereich im Unterschied zu der vorausgesagten Verschiebung in den IR-Bereich.

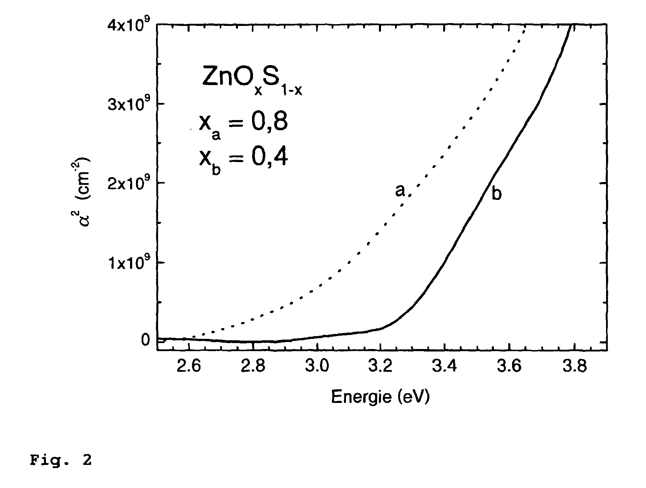

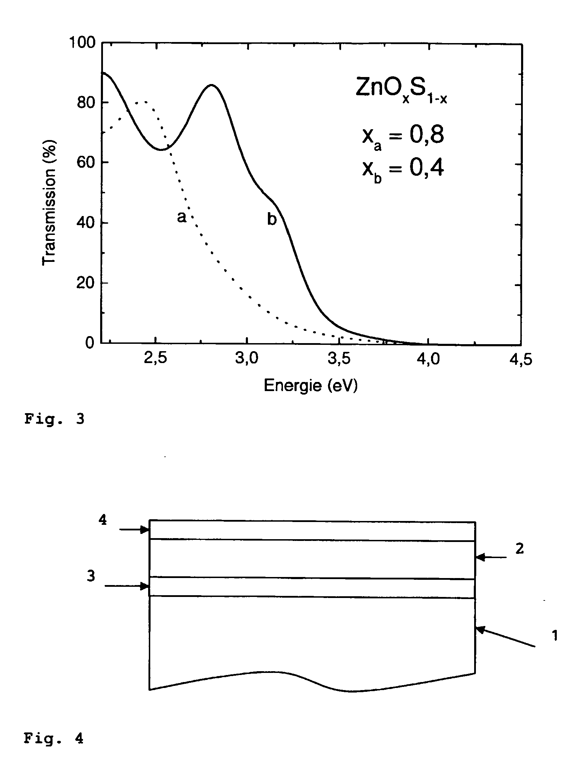

Fig. 2 zeigt als Beispiel den Absorptionskoeffizienten einer ZnOS Schicht mit einem Sauerstoffanteil x=0.4 und x=0.8 auf Floatglas als Substrat. Die Absorptionskante ist steil mit einer exzitonischen Überhöhung und besitzt einen ausgezeichneten Hub (Differenz der Transmission oberhalb und unterhalb der Bandlücke (siehe Fig. 3)). Erfindungsgemäß lässt sich die Absorptionskante im gewünschten Wellenlängen- oder Energiebereich bei großem Hub kontrolliert einstellen, z.B. bei 380 nm, 390 nm, 400 nm. Daraus ergibt sich, dass gewisse Bereiche des Lichtspektrums abgeschnitten werden, z.B. der UV-A-Bereich.

Zudem betrifft die Erfindung ein Verfahren zur Herstellung der beschriebenen Schicht. Diese zweite Aufgabe wird gelöst durch das Verfahren gemäß Anspruch 5.

Die dritte Aufgabe der Erfindung betrifft die Vorsehung eines optischen Funktionselementes. Diese letzte Aufgabe wird gelöst durch das Funktionselement gemäß Anspruch 13.

## [Beispiele]

Die Figuren 1, 2 und 3 zeigen Messwerte zu $ZnO_xS_{(1-x)}$ mit x aus dem Bereich x nahe 0 bis x = 1 (ZnO), wobei sich die Erfindung auf den Bereich 0,4 bis 0,8 beschränkt.

Die optische Funktionsschicht kann auf einer Substratschicht aus gängigem transparentem Material wie z.B.

Glas oder Plexiglas oder nicht transparentem Material aufgebracht werden. Die Funktionsschicht ist kristallin und stellt ein Übergangssystem zwischen ZnO (Bandabstand 3,4 eV) und ZnS (Bandabstand 3,7 eV) dar. Je nach eingestelltem O:S-Verhältnis liegt die Bandkante im Zwischenbereich zwischen ca. 2,5 und 3,7 eV (mit Messfehlern ggf. zwischen 2.5 - 3.9 eV). Damit kann eine Funktionsschicht mit dem gewünschten Bandabstand konfektioniert werden.

Zur Herstellung wird das Substrat mit einem der bekannten Dünnschicht-Depositionsverfahren, nämlich mit der Sputtertechnik, mit der erfindungsgemäßen Schicht beschichtet.

Eine Abwandlung des Verfahrens und damit ein vorteilhaftes Ausführungsbeispiel zum erfindungsgemäßen Verfahren ergibt sich, wenn zunächst auf das Substrat eine Nukleationsschicht aufgebracht wird, auf welche die Funktionsschicht aufgebracht wird. Als Nukleationsschicht eignen sich besonders solche, die eine ähnliche Struktur und Gitterkonstante, inbesondere bei der Depositionstemperatur der Funktionsschicht, aufweisen.

Auf diese Weise kann das Wachstum der $ZnO_xS_{(1-x)}$-Schicht verbessert und die erforderliche Substrattemperatur gesenkt werden. Dies ist vorteilhaft einerseits im Hinblick auf die Prozesskosten, da ein zeit- und energieaufwendiges Vorheizen des Substrates vermieden werden kann; andererseits können so schädigende Effekte auf das Substrat ausgeschlossen werden, die insbesondere bei organischen Materialen von Bedeutung sind.

Weitere Einzelheiten und vorteilhafte Weiterbildungen der Erfindung ergeben sich aus den im folgenden beschriebenen und in den Zeichnungen dargestellten Ausführungsbeispielen, sowie aus den Unteransprüchen. Es zeigt:

Fig. 1: die Verschiebung der Bandlücke legierter $ZnO_xS_{(1-x)}$ Schichten (in eV) als Funktion des Sauerstoffanteils x im Bereich von 0 < x < 1, wobei sich die Erfindung auf den Bereich x = 0,4 bis x = 0,8 beschränkt.

Fig. 2: das Quadrat des Absorptionskoeffizienten ($\alpha^2$ in cm$^2$) zweier erfindungsgemäßer Funktionsschichten auf Floatglas als Substrat mit einem Sauerstoffanteil von $x_a$=80% und $x_b$=40%, als Funktion der Energie in eV.

Fig. 3: die Transmission (in %) der beiden Funktionsschichten aus Fig. 2 ($x_a$ = 80% und $x_b$ = 40%) mit Floatglas als Substrat im Bereich der Absorptionskante, in Abhängigkeit von der Energie (eV).

Fig. 4: den Aufbau eines Schichtsystems als optisches Funktionselement auf einem Substrat umfassend -in Richtung vom Substrat nach oben- eine Nukleationsschicht zur Verbesserung der Funktionsschicht-Abscheidung, die Funktionssicht als solche und darüber eine Schutzschicht.

Fig. 1 zeigt die Bandlücke in Abhängigkeit vom Sauerstoffanteil x von 9 untersuchten $ZnO_xS_{(1-x)}$ Funktionsschichten. Deutlich zu erkennen ist, dass die Bandlücke im Bereich von ca. 3.9 eV bis runter zu ca. 2.4 eV einstellbar ist, wenn der Anteil des Sauerstoffgehaltes im Bereich zwischen x=0 und x=1 variiert wird. Prinzipiell ist natürlich auch der Schwefelgehalt variierbar, wenn statt dem ZnS ein ZnO-Target verwendet wird und der Zustrom an Schwefel eingestellt wird.

Fig. 2 zeigt die deutliche Verschiebbarkeit der Bandlücke durch Wahl des Sauerstoffanteils x des in der Funktionsschicht. Gleiches gilt bei Variation des Schwefelgehaltes (siehe oben).

Fig. 3a zeigt die deutliche Abnahme der Transmission von ca. 80% auf nahe 0% innerhalb eines Bereiches der Bandenergie von ca. 0.75 eV.

Fig. 4 zeigt ein optisches Funktionselement, bestehend aus einem Schichtsystem, aufweisend eine erfindungsgemäße Funktionsschicht oberhalb einer auf einem Substrat angebrachten Nukleationsschicht. Die Nukleationsschicht sorgt dabei für ein verbessertes Wachstum (bei tieferen Depositionstemperaturen).

Zur Vermeidung der Beeinträchtigung der Wirkung der Funktionsschicht durch mechanische, oder chemische Beschädigung oder Verschmutzung weist das Schichtsystem noch eine Schutzschicht oberhalb der Funktionsschicht auf. Als Schutzschichten kommen in Frage z.B.: $SiO_2$, SiN, SiON, $Al_2O_3$ und weiter optische durchlässige und ausreichend harte Schichte.

Natürlich kann es für manche Anwendungen auch sinnvoll sein, verschiedene anderer Schutzschichten oberhalb der ersten oder unterhalb des Substrates zusätzlich anzubringen.

Eine besonders vorteilhafte Ausgestaltung des optischen Funktionselementes besteht darin oberhalb der optischen Funktionsschicht oder/und unterhalb des Substrates eine Antioxidationsschicht (5) anzubringen.

Im folgenden wird eine Funktionsschicht und deren Herstellung exemplarisch vorgestellt. Zur Herstellung wurde als Target ZnS gewählt, und über den Sauerstoffzustrom der Parameter x des Anteils von Sauerstoff in der sich ergebenden Schicht und damit die Bandlücke eingestellt.

| Probe | ZnOS - Nr. 077 | |
|---|---|---|
| Substrat: | Saphir, (alternativ auch Suprasil oder Float- glas) | |
| Druck in Kammer: | $4,0 \times 10^{-3}$ Pa | |
| Target: | ZnS | |

(fortgesetzt)

| Probe | ZnOS - Nr. 077 | |
|---|---|---|
| Schicht: | $ZnO_xS_{1-x}$ | |
| Gasfluss Ar: | 4,2 sccm | |
| Gasfluss $O_2$: | 0,9 sccm | |
| | | |
| | Vorsputtern (Reinigung) | Sputtern (Schichtdeposi- |
| Druck | 2,1 Pa | 2,0 Pa |
| Sputterleistung | 300 W | 300 W |
| Spannung Target-ubstrat durch Selbstaufladung | 3,3 kV | 3,15 kV |
| Substrat-Temperatur | 300 °C | 300 °C auf 360 °C ansteigend |
| Sputterzeit | 10 min | 30 min |
| | | |
| Zusammensetzung der Schicht in Atom% | | |
| Zn | O | S |
| 54 | 33 | 12 |

Mit diesem Ergebnis ist Fig. 1 zu entnehmen, dass die Funktionsschicht eine Bandlücke im Bereich von ca. 2.7 bis 2.9 eV aufweist. Damit ergibt sich -aufgrund des ähnlichen Sauerstoffanteils- ein Verlauf des Absorptionskoeffizienten und des Transmissionskoeffizienten (s. Fig. 2, 3) ähnlich zu denen für $x_b=0.4$.

Die erfindungsgemäße Funktionsschicht kann generell überall dort verwendet werden, wo eine Abscheidung auf einem Substrat möglich ist und das Substrat selber oder darunter liegende Material vor UV-Einstrahlung zu schützen sind. Damit gehören zu den Anwendungsfeldern -nicht abschliessend- folgende Bereiche: Beschichtungen für a) Architekturglas, b) UV-Schutzgläser für PKW, Sonnenbrillen, Sonnenbänke, Lebensmittelverpackungen, etc., c) Textilien für Menschen oder generell Textilien.

Ausserdem ist die optische Funktionsschicht auch -aufgrund der Reflexionsminderung- als Ersatz für dielektrische Schichten in opto-elektronischen Anwendungen verwendbar.

Dem Fachmann ist unmittelbar einsichtig, dass die Funktionsschicht auch auf flexible Substrate übertragbar ist.

Ferner ist dem Fachmann einsichtig, dass die Funktionsschicht auch als Antireflexionsschicht einsetzbar ist.

**[Bezugszeichenliste]**

1    Substrat

2    Funktionsschicht

3    Nukleationsschicht

4    Schutzschicht

5    Antioxidationsschicht

**Patentansprüche**

1. Verfahren zur Herstellung einer optischen Funktionsschicht aus $ZnO_xS_{(1-x)}$ in kristalliner Form mittels Sputter-Technik, umfassend die Schritte:

a) Bereitstellung eines Substrates aus der Gruppe umfassend Floatglas-, Suprasil- oder Saphir-Substrate,

b) Bereitstellung von ZnS als keramisches Target;

c) Zuführung von Sauerstoff und Zuführung von Argon und Einstellung der Zuführungen gemäß des gewünschten Wertes der Wellenlänge der Absorptionskante in einem Bereich zwischen 2,5 eV und 3,7 eV;

d) Abscheidung der erzeugten $ZnO_xS_{(1-x)}$-Legierung auf dem Substrat entsprechend der gewünschten Schichtdicke;

wobei vor dem Schritt der Deposition der Funktionsschicht (2) eine Nukleationsschicht (3) auf das Substrat aufgebracht wird und dass für die Abscheidung ein Arbeitsdruck von ca. 2 Pa und eine Sputterleistung von ca. 300 W bei einer Spannung Target-Substrat von ca. 3-3,5 kV gewählt wird und die Substrattemperatur von 300°C auf 360°C ansteigt, sodass eine kristalline $ZnO_xS_{(1-x)}$- Schicht mit x zwischen 0,4 und 0,8 entsteht, die eine Kristallstruktur vom Wurtzit-Typ aufweist.

2. Optische Funktionsschicht, die nach einem Verfahren zur Herstellung einer optischen Funktionsschicht nach Anspruch 1 hergestellt ist und aus $ZnO_xS_{(1-x)}$ in kristalliner Form besteht, wobei sie eine Legierung mit einem gemäß des gewünschten Wertes der Wellenlänge der Absorptionskante eingestellten Gehalt an Sauerstoff und Schwefel ist, wobei x zwischen 0,4 und 0,8 liegt und die Schicht eine Kristallstruktur vom Wurtzit-Typ aufweist.

3. Funktionsschicht nach Anspruch 2, **dadurch gekennzeichnet, dass** sie mit Floatglas als Substrat (1) im Bereich der Absorptionskante eine Abnahme der Transmission von 80 % auf nahe 0 % innerhalb eines Bereichs der Bandenergie von 0,75 eV aufweist.

4. Funktionsschicht nach Anspruch 2 oder 3, **dadurch gekennzeichnet, dass** sie für x = 0,73 eine Bandlücke von 2,7 bis 2,9 eV aufweist.

5. Optisches Funktionselement, **dadurch gekennzeichnet, dass** es die Funktionsschicht (2) nach einem der Ansprüche 2 bis 4 sowie ein Substrat (1) und mindestens eine Schutzschicht (4) und/oder mindestens eine Antioxidansschicht (5) aufweist.

6. Verwendung der Funktionsschicht nach einem der Ansprüche 2 bis 5 als Schutz vor UV-Strahlung, insbesondere für Flugzeuge, z.B. Sichtfenster oder Teile der Aussenhaut, für Gläser insbesondere für Architektur- oder Brillengläser, für Kraftfahrzeuge, z.B. Gläser oder Kunststoffteile, für Kunststoffe, insbesondere Lebensmittelverpackungen oder für Textilien.

7. Verwendung der Funktionsschicht nach einem der Ansprüche 2 bis 5 zur Ersetzung von dielektrischen Schichten in opto-elektronischen Anwendungen.

**Claims**

1. Procedure for the manufacture of an optical functional layer of $ZnO_xS_{(1-x)}$ in crystalline form by means of sputter technique, comprising the steps:

a) provision of a substrate of the group comprising float-glass-, Suprasil-, or sapphire substrates,

b) provision of ZnS as ceramic target;

c) feeding of oxygen and feeding of argon and regulation of the feedings according to the desired wavelength value of the absorption edge in a range between 2,5 eV and 3,7 eV;

d) elimination of the created $ZnO_xS_{(1-x)}$ alloy on the substrate according to the desired layer thickness;

at which before the step of the deposition of the functional layer (2) a nucleation layer (3) is applied to the substrate, and that for the elimination a working pressure of about 2 Pa and a sputter power of about 300 W at a target substrate tension of about 3-3,5 kV is chosen and the substrate temperature rises from 300° C to 360° C to create a crystalline $ZnO_xS_{(1-x)}$ layer with x between 0,4 and 0,8 and showing a crystal structure of the Wurtzit type.

2. Optical functional layer manufactured according to a procedure for the manufacture of an optical functional layer according to Claim 1 and consisting of $ZnO_xS_{(1-x)}$ in crystalline form, and being an alloy of a contents of oxygen and sulphur regulated according to the desired value of the wavelength of the absorption edge, with x lying between 0,4 and 0,8 and the layer having a crystal structure of the Wirtzit type.

3. Functional layer according to Claim 2, **characterized in that** with float-glass as substrate (1) it shows in the section of the absorption edge a reduction of transmission from 80% to near 0% within a range of the band energy of 0,75 eV.

4. Functional layer according to Claim 2 or 3, **characterized in that** it shows for x = 0,73 a band gap from 2,7 to 2,9 eV.

5. Optical functional element, **characterized in that** it has the functional layer (2) according to one of the Claims 2 to 4, as well as a substrate (1) and at least one protective layer (4) and/or at least one antioxidant layer (5).

6. Use of the functional layer according to one of the Claims 2 to 5 as UV-ray protection, especially for airplanes, e. g. for windows or parts of the shell, for glasses, especially for architectural glasses or spectacle lenses, for motor vehicles, e. g. glasses or plastic parts, for plastics, especially food wrappers, or for textiles.

7. Use of the functional layer according to one of the Claims 2 to 5 to substitute dielectric layers in opto-electronic use.

**Revendications**

1. Procédé pour la production d'une couche fonctionnelle optique de $ZnO_xS_{(1-x)}$ en forme cristalline par technique de pulvérisation, comprenant le les pas :

   a) mise à disposition d'un substrat de la fonction comprenant les substrats verre flotté, suprasil, ou saphir,
   b) mise à disposition de ZnS comme cible céramique ;
   c) alimentation d'oxygène et alimentation d'argon et réglage des alimentations selon la valeur souhaitée de la longueur d'onde de l'arête d'absorption dans une zone entre 2,5 eV et 3,7 eV ;
   d) précipitation de l'alliage $ZnO_xS_{(1-x)}$ sur le substrat selon l'épaisseur de couche souhaitée ;

   et par quoi avant le pas de la déposition de la couche fonctionnelle (2) une couche nucléaire (3) est appliquée sur le substrat, et que pour la précipitation est choisie une pression de service d'environ de 2 Pa et une puissance de pulvérisation d'environ de 300 W à une tension substrat cible d'environ de 3-3,5 kV, et la température du substrat monte de 300° C à 360° C, pour ainsi créer une couche cristalline de $ZnO_xS_{(1-x)}$ avec x entre 0,4 et 0,8, et d'une structure cristalline type wurtzite.

2. Couche fonctionnelle optique produite selon un procédé pour la production d'une couche fonctionnelle optique selon la Revendication 1 et qui consiste de $ZnO_xS_{(1-x)}$ en forme cristalline, et qui est une alliage d'un contenu d'oxygène et de soufre réglé selon la valeur souhaitée de la longueur d'onde de l'arête d'absorption, avec x étant entre 0,4 et 0,8 et la couche ayant une structure cristalline type wurtzite.

3. Couche fonctionnelle optique selon la Revendication 2, **caractérisée en ce qu'**avec la verre flotté comme substrat (1) elle montre dans la section de l'arête d'absorption une réduction de la transmission de 80% à presque 0% dans la zone de l'énergie de bande de 0,75 eV.

4. Couche fonctionnelle selon la Revendication 2 ou 3, **caractérisée en ce que** pour x = 0,73 elle montre un écart énergétique de 2,7 à 2,9 eV.

5. Elément fonctionnel optique, **caractérisée en ce qu'**il a la couche fonctionnelle (2) selon une des Revendications 2 à 4, et un substrat (19, et au moins une couche protectrice (4), et/ou au moins une couche antioxygène (5).

6. Emploi de la couche fonctionnelle selon une des Revendications 2 à 5, comme protection contre le rayonnement ultraviolet, particulièrement pour les avions, par exemple fenêtres ou parties du bordé, pour des verres, particulièrement pour verres architecturaux ou verres de lunettes, pour les véhicules, par exemple verres ou pièces en matière plastique, pour les matières plastiques, particulièrement emballages alimentaires, ou pour les textiles.

7. Emploi de la couche fonctionnelle selon une des Revendications 2 à 5 pour remplacer les couches diélectriques dans des applications opto-électroniques.

# Fig. 1

Anpassungskurve

Bandlücke (eV)

"x" - Anteil von $ZnO_xS_{1-x}$

Fig. 2

Fig. 3

Fig. 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• US 20030042851 A1, Iwata

**In der Beschreibung aufgeführte Nicht-Patentliteratur**

• **Y.-Z. Yoo et al.** *Appl. Phys. Lett.,* 2002, vol. 81, 3798
• **T. Makino et al.** *Appl. Phys. Lett.,* 2001, vol. 78, 1237
• **Yousfi et al.** *Thin Solid Films,* 2000, vol. 361 - 36, 183-186
• **Orent et al.** *J. Vac. Sci. Technol. A,* Juli 1991, vol. 9 (4